Europäisches Patentamt

European Patent Office

Office européen des brevets

(11) Veröffentlichungsnummer: **0 279 240**
**A2**

(12) **EUROPÄISCHE PATENTANMELDUNG**

(21) Anmeldenummer: 88101189.4

(22) Anmeldetag: 27.01.88

(51) Int. Cl.⁴ **H01J 37/244**

(30) Priorität: 16.02.87 DE 3704865

(43) Veröffentlichungstag der Anmeldung:
24.08.88 Patentblatt 88/34

(84) Benannte Vertragsstaaten:
DE FR GB NL

(71) Anmelder: **Siemens Aktiengesellschaft Berlin und München**
**Wittelsbacherplatz 2**
**D-8000 München 2(DE)**

(72) Erfinder: **Brunner, Matthias, Dr.**
**Graf-Andechs-Strasse 30**
**D-8011 Kirchheim(DE)**

(54) **Detektor für geladene Teilchen.**

(57) Der erfindungsgemäße Detektor besteht im wesentlichen aus drei durch isolierende Abstandshalter (AH) voneinander getrennten und annähernd parallel zur Oberfläche einer Probe angeordneten Gitterelektroden (AE, AG, GE) und einem die Probe (PR) nahezu vollständig überdeckenden elektronensensitiven Teil, der eine Vielzahl stabförmiger Szintillatoren (SZ) oder mit Szintillationsmaterial beschichtete Lichtleiter aufweist. Die Szintillatorstäbe (SZ), die zur Nachbeschleunigung der Sekundärelektronen (SE) auf einem hohen positiven Potential ($V_{SZ}$) liegen, sind ebenfalls in einer annähernd parallel zur Probenoberfläche liegenden Ebene angeordnet, wobei die Stablänge jeweils annähernd den Abmessungen der Probe (PR) in der durch die Stablängsachse definierten Richtung entspricht. Die unmittelbar ober-und unterhalb der Szintillatorstäbe (SZ) angeordneten Gitterelektroden (AE bzw. RE) dienen der Abschirmung des elektronensensitiven Teils (SZ) vor rückgestreuten Elektronen (RE) und den von diesen ausgelösten Sekundärelektronen (SE). Die unmittelbar oberhalb der Probe (PR) angeordnete Gegenfeldelektrode (GE) ermöglicht den energieempfindlichen Nachweis der Sekundärelektronen (SE).

FIG 2

## Detektor für geladene Teilchen

Die Erfindung betrifft einen Detektor für geladene Teilchen nach dem Oberbegriff des Patentanspruchs 1.

Trifft ein primärer Teilchenstrahl auf einen Festkörper, so werden aufgrund der Wechselwirkung der Primärteilchen mit der Festkörpersubstanz Sekundärteilchen emittiert, deren Energie-und Winkelverteilung u. a. von der im Wechselwirkungsbereich vorliegenden chemisch-physikalischen Zusammensetzung, der Oberflächenstruktur und der auf der Probe vorhandenen Potentialverteilung abhängt. Von besonderer Bedeutung für die Bilderzeugung in Rasterelektronenmikroskopen sind die in oberflächennahen Bereichen ausgelösten Sekundärelektronen, die man beispielsweise mit einem seitlich oberhalb der abzubildenden Probe angeordneten Detektor nachweist. Infolge der unsymmetrischen Anordnung des üblicherweise aus einer Absaugelektrode, einem Szintillator und einem Lichtleiter bestehenden Detektors (siehe beispielsweise J. Sc. Instr:, Vol. 37, Juli 1960, Seite 246-248) innerhalb der Probenkammer, wird die Nachweiswahrscheinlichkeit der Sekundärelektronen und damit die im Detektor gemessene Signalhöhe entscheidend von deren Auslösepunkt auf der Probe beeinflußt. Ein Detektorsystem mit mehreren Einzeldetektoren ist aus der europäischen Patentschrift 0 018 031 bekannt. Derartige Mehrdetektorsysteme werden vor allem zur Untersuchung großflächiger Proben eingesetzt, um ein weitgehend symmetrisches, vom Emissionsort und Emissionswinkel unabhängiges Absaugen der Sekundärelektronen zu gewährleisten. Diese Detektoranordnungen besitzen allerdings den Nachteil, daß dem gemessenen Sekundärelektronensignal aufgrund der gegenüber Einzeldetektoren verfielfachten Detektorfläche ein durch Rückstreuelektronen erzeugtes Störsignal überlagert ist.

Der vorliegenden Erfindung liegt die Aufgabe zugrunde, ein Detektor der eingangs genannten Art anzugeben, bei dem die Nachweiswahrscheinlichkeit unabhängig vom Auslösesort der Teilchen oder Strahlung auf der Probe ist. Weiterhin soll ein teilchenselektiver Nachweis gewährleistet sein.

Diese Aufgabe wird erfindungsgemäß durch einen Detektor nach Patentanspruch 1 gelöst.

Der mit der Erfindung erzielbare Vorteil besteht insbesondere darin, daß dem im Detektor erzeugten Topographie-, Material-oder Potentialkontrastsignal keine durch die Detektorgeometrie bedingten ortsabhängigen Störungen überlagert sind. Außerdem wird der Beitrag rückgestreuter Primärteilchen zum Meßsignal erheblich reduziert.

Die Ansprüche 2 bis 16 sind auf bevorzugte Ausgestaltungen und Weiterbildungen der Erfindung gerichtet, die im folgenden anhand der Zeichnungen erläutert wird.

Hierbei zeigt:

FIG 1 ein Ausführungsbeispiel eines erfindungsgemäßen Detektors für den energieempfindlichen Nachweis von Sekundärelektronen.

FIG 2 den schematischen Aufbau der teilchensensitiven Bereiche des erfindungsgemäßen Detektors nach FIG 1.

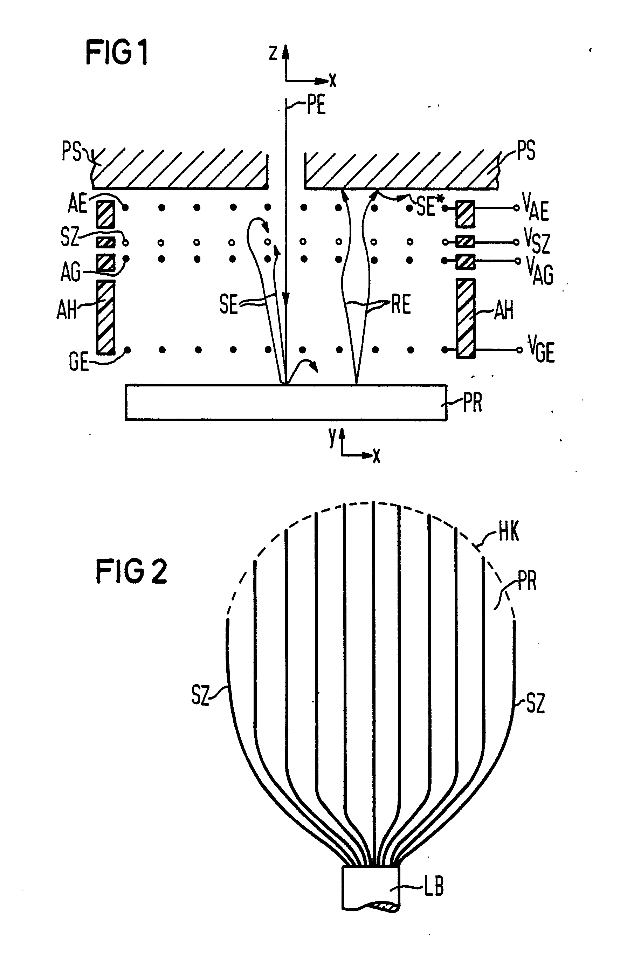

Der in FIG 1 schematisch dargestellte Detektor dient dem Nachweis von Sekundärelektronen SE, die von einem beispielsweise in einem Rasterelektronenmikroskop erzeugten Primärelektronenstrahl PE auf der zu untersuchenden Probe PR ausgelöst werden. Der unmittelbar unterhalb der Polschuhplatte PS der Objektivlinse des Rasterelektronenmikroskopes angeordnete Detektor besteht im wesentlichen aus drei durch isolierende Abstandshalter AH voneinander getrennten und annähernd parallel zur Probenoberfläche angeordneten Gitterelektroden GE/AG/AE und einem die Probe PR nahezu vollständig überdeckenden elektronensensitiven Teil, der eine Vielzahl stabförmiger Szintillatoren SZ oder mit Szintillationsmaterial beschichtete Lichtleiter aufweist. Diese Szintillatorstäbe SZ, die zur Nachbeschleunigung der mit niedrigen kinetischen Energien emittierten Sekundärelektronen SE ($E_{SE} \leq 50$ eV) auf einem hohen positiven Potential $V_{SZ}$ von beispielsweise $V_{SZ} = + 10$ kV liegen, sind ebenfalls in einer Ebene parallel zur Probenoberfläche angeordnet, wobei deren Länge jeweils annähernd den Abmessungen der Probe PR in der durch die Stabslängsachse definierten Richtung entspricht. Eine die Stabenden verbindende Hüllkurve HK kann hierbei wie in FIG 2 dargestellt die Form eines Halbkreises oder eine andere der Begrenzung der jeweils untersuchten Probe PR entsprechende Form annehmen. Um die in den vorzugsweise mit konstantem Abstand parallel zueinander angeordneten Szintillator-oder Lichtleiterstäbe SZ durch auftreffende Sekundärelektronen SE erzeugten Lichtimpulse in der bekannten Signalkette des Rasterelektronenmikroskopes in ein elektrisches Signal umzuwandeln, werden die Stäbe SZ außerhalb des abzutastenden Probenbereichs gebündelt und ggf. unter Zwischenschaltung eines lichtdurchlässigen Blockes LB oder eines weiteren Lichtleiters der Fotokathode eines Multipliers zugeführt. Zur Unterdrückung der Signalbeiträge rückgestreuter Primärelektronen RE ist der Detektor vorteilhafterweise mit einem unmittelbar unterhalb der Ebene der Szintillatorstäbe SZ parallel zur Probenoberfläche angeordneten und auf Erdpotential oder einem negativen Potential $V_{AG}$ legenden Gitterelektrode AG ausgestattet. Da deren Gitterstege als schwach fokussierende Linse wirken, werden sowohl die niederenergetischen Sekundärelektronen ($E_{SE} \leq 50$ eV) als auch die hochenergetischen Rückstreuelektronen RE ($E_{RE} \approx E_{PE}$ = Energie der Primärelektronen 3 bis 10 keV) in Richtung der Stabzwischenräume abgelenkt (in FIG 1 wurden aus Gründen der Übersichtlichkeit verschiedene Auslösepunkte für Rückstreuelektronen und Sekundärelektronen dargestellt). Die nur schwache Ablenkung der hochenergetischen Rückstreuelektronen RE im Feld der Gitterelektrode AG ist ausreichend, deren Absaugung in Richtung der auf positivem Potential $V_{SZ}$ liegenden Szintillatorstäbe SZ bzw. Lichtleiter zu unterbinden. Um auch die Signalbeiträge der an der Objektivlinse von auftreffenden Rückstreuelektronen RE ausgelösten Sekundärelektronen SE* zu unterdrücken, wird ein auf negativem Potential $V_{AE}$ von beispielsweise -50 Volt liegendes Abschirmgitter AE unmittelbar unterhalb der Polschuhplatte PS parallel zur Ebene der Szintillatorstäbe SZ angeordnet. Das Abschirmgitter AE unterstützt außerdem die Wirkung des Absaugfeldes der Szintillatorstäbe SZ, indem es die in Richtung der Stabzwischenräume fokussierten Sekundärelektronen SE auf die Szintillatoren zurücktreibt, ohne die rückgestreuten Elektronen RE wesentlich zu beeinflußen. Die Zahl der an der Objektivlinse ausgelösten Sekundärelektronen SE* kann auch durch die Beschichtung der Polschuhplatte PS mit Kohlenstoff oder einem anderen Material mit niedriger Sekundärelektronenausbeute weiter reduziert werden.

Um einen energieempfindlichen Nachweis der Sekundärelektronen SE zu ermöglichen, ist der erfindungsgemäße Detektor mit einem unmittelbar oberhalb der Probe PR und annähernd parallel zu deren Oberfläche angeordneten Gegenfeldelektrode GE ausgestattet. Mit dieser auf einem variablen negativen Potential $V_{GE}$ liegenden Gitterelektrode GE wird ein Potentialwall aufgebaut, den nur Sekundärelektronen SE mit Energien oberhalb einer vorgegebenen Mindestenergie überwinden können. Ein solcher Detektor wird insbesondere für das Elektronenstrahltesten von großflächigen Leiterplatten (Größe etwa 10 × 10 cm) und Mikroverdrahtungsschaltungen benötigt, wo man die mittlere Energie der ausgelösten Sekundärelektronen SE als Maß für das Potential des bestrahlten Kontaktpunktes auswertet. Auf die Gegenfeldelektrode GE kann ggf. verzichtet werden, wenn man die Gitterelektrode AG mit einem die gewünschte Mindestenergie definierenden Potential beaufschlagt.

Bei Verwendung einer Gegenfeldelektrode GE sollte der Abstand zur Gitterelektrode AG groß gegen den Abstand ihrer Gitterstege sein. Weiterhin sollte der Abstand der Gitterelektrode AG zur Ebene der Szintillatorstäbe SZ möglichst klein gewählt werden, ohne den durch die Hochspannung $V_{SZ}$ an den Szintillatorstäben SZ definierten Mindestabstand zu unterschreiten. Der Abstand der Lichtleiter bzw. Szintillatorstäbe SZ und deren Dicke ist u. a. von der Größe der Probe PR abhängig. Für eine Probenoberfläche von 10 × 10 cm kann die Stabdicke beispielsweise maximal 1 mm und der Stababstand etwa 5 mm betragen.

Die Erfindung ist selbstverständlich nicht auf die in den Figuren dargestellten Ausführungsbeispiele beschränkt. So können die Gitterelektroden auch mit anderen Potentialen beaufschlagt werden. Deren Größe muß für die gewählten Gitterdimensionen jeweils berechnet oder experimentell bestimmt werden. Es ist auch nicht notwendig, alle in Fig. 1 dargestellten Elektroden in einem erfindungsgemäßen Detektor zu verwenden. So kann beispielsweise auf die Elektroden AG und AE verzichtet werden, wobei dann allerdings mit einem erhöhten Störsignal durch rückgestreute Elektronen gerechnet werden muß.

**Ansprüche**

1) Detektor mit mehreren teilchensensitiven Bereichen und mindestens einer Einrichtung zur Weiterleitung der in verschiedenen teilchensensitiven Bereichen durch auftreffende geladene Teilchen oder Strahlung erzeugten Signale, dadurch **gekennzeichnet**, daß die teilchensensitiven Bereiche (SZ) in einer annähernd parallel zur Oberfläche einer Probe (PR) liegenden Ebene angeordnet sind und daß deren in Richtung einer in dieser Ebene liegenden Geraden gemessene Ausdehnung etwa den Abmessungen der Probe (PR) in dieser Richtung entspricht.

2) Detektor nach Anspruch 1, dadurch **gekennzeichnet**, daß sich die teilchensensitiven Bereiche (SZ) nur über Teilbereiche der parallel zur Oberfläche der Probe (PR) liegenden Ebene erstrecken.

3) Detektor nach Anspruch 1 oder 2, dadurch **gekennzeichnet**, daß die teilchensensitiven Bereiche (SZ) stabförmig ausgebildet und parallel zueinander angeordnet sind.

4) Detektor nach einem der Ansprüche 1 bis 3, **gekennzeichnet** durch einen Szintillator (SZ) als teilchensensitiver Bereich.

5) Detektor nach einem der Ansprüche 1 bis 3, **gekennzeichnet** durch einen mit einem Szintillatormaterial beschichteten Lichtleiter als teilchensensitiver Bereich.

6) Detektor nach einem der Ansprüche 1 bis 5, **gekennzeichnet** durch eine annähernd parallel zur Probenoberfläche und unmittelbar unterhalb der teilchensensitiven Bereiche (SZ) angeordnete erste Elektrode (AG).

7) Detektor nach Anspruch 6, dadurch **gekennzeichnet**, daß die erste Elektrode (AG) auf Erdpotential oder einem negativen Potential ($V_{AG}$) liegt.

8) Detektor nach einem der Ansprüche 1 bis 7, **gekennzeichnet** durch eine annähernd parallel zur Probenoberfläche und unmittelbar oberhalb der teilchensensitiven Bereiche (SZ) angeordnete zweite Elektrode (AE).

9) Detektor nach Anspruch 8, dadurch **gekennzeichnet**, daß die zweite Elektrode (AE) unmittelbar unterhalb des Polschuhes (PS) der abbildenden Linse eines strahlerzeugenden Systems angeordnet ist.

10) Detektor nach einem der Ansprüche 1 bis 9, **gekennzeichnet** durch eine annähernd parallel zur Probenoberfläche und unmittelbar unterhalb der ersten Gitterelektrode (AG) angeordnete dritte Elektrode (GE).

11) Detektor nach einem der Ansprüche 8 bis 10, dadurch **gekennzeichnet**, daß die Polarität der an der zweiten und der dritten Elektrode (AE, GE) anliegenden Potentiale ($V_{AE}$, $V_{GE}$) so gewählt ist, daß die nachzuweisenden Teilchen abgebremst werden.

12) Detektor nach einem der Ansprüche 1 bis 11, dadurch **gekennzeichnet**, daß die Einrichtung zum Weiterleiten der Signale aus einem Lichtleiter oder einem lichtleitenden Block (LB) besteht, mit dem die teilchensensitiven Bereiche (SZ) jeweils über einen Lichtleiter kleineren Querschnitts verbunden sind.

13) Detektor nach einem der Ansprüche 1 bis 12, dadurch **gekennzeichnet**, daß der Abstand zwischen der ersten (AG) und der dritten Elektrode (GE) und der Abstand zwischen der zweiten Elektrode (AE) und der Ebene der teilchensensitiven Bereiche (SZ) größer als der Abstand zwischen der ersten Elektrode (AG) und der Ebene der teilchensensitiven Bereiche (SZ) ist.

14) Detektor nach einem der Ansprüche 1 bis 13, dadurch **ge kennzeichnet**, daß die erste, zweite und dritte Elektrode (AG, AE, GE) die Probenoberfläche nahezu vollständig überdecken.

15) Detektor nach einem der Ansprüche 1 bis 14, dadurch **gekennzeichnet**, daß die erste, zweite und dritte Elektrode (AG, AE, GE) jeweils als Gitterelektrode ausgebildet sind.

16) Detektor nach Anspruch 15, dadurch **gekennzeichnet**, daß der Abstand der Stege der Gitterelektroden (AG, AE, GE) jeweils annähernd dem Abstand benachbarter teilchensensitiver Bereiche (SZ) entspricht.

# FIG 1

# FIG 2